# EUROPEAN PATENT SPECIFICATION

(11) **EP 3 671 817 B1**
(45) Date of publication and mention of the grant of the patent: **04.05.2022**
(21) Application number: 18846613.0
(22) Date of filing: 30.07.2018
(51) Int. Cl.: H01L 21/66, C30B 29/06, G01N 21/64, G01N 21/27, C30B 15/00, C30B 13/00

(54) **CARBON CONCENTRATION MEASUREMENT METHOD**
VERFAHREN ZUR MESSUNG DER KOHLENSTOFFKONZENTRATION
PROCÉDÉ DE MESURE DE CONCENTRATION EN CARBONE

(30) Priority: 18.08.2017 JP 2017157924
(43) Date of publication of application: 24.06.2020
(73) Proprietor: Shin-Etsu Handotai Co., Ltd., Tokyo 100-0004 (JP)
(72) Inventor: KIMURA Akihiro, Nishishirakawa-gun Fukushima 961-8061 (JP)
(74) Representative: Wibbelmann, Jobst
(86) International application number: PCT/JP2018/028362
(87) International publication number: WO 2019/035343

(56) References cited:
- EP-A1- 2 952 883
- JP-A- H04 344 443
- JP-A- 2012 102 009
- JP-A- 2013 152 977
- JP-A- 2015 101 529
- JP-A- 2015 101 529

## Description

### TECHNICAL FIELD

The present invention relates to a method for measuring carbon concentration in a semiconductor sample, especially a silicon wafer, and more particularly to a method for measuring carbon concentration in an FZ silicon single crystal (which will be referred to as an FZ single crystal) manufactured by a floating zone (FZ) method.

### BACKGROUND ART

In semiconductor wafers each of which is used as a CIS (CMOS image sensor) or a power device substrate, realization of a high lifetime has been demanded, and a decrease of carbon has been requested to avoid a reduction in lifetime, and accurately measuring low carbon concentration is very important. Measuring the carbon concentration by an FT-IR method (Fourier transformation infrared spectroscopy) has been possible heretofore, but the sensitivity is poorer than a recent request level. Compared to this, a low-temperature photoluminescence (PL) method has high sensitivity.

According to the PL method, light having energy larger than a bandgap is used as an excitation source, and excited electron-hole pairs are formed when a silicon wafer is irradiated with excitation light. This is a method for detecting light emission (luminescence) at the time of recombination of these pairs through a metastable state, and evaluating/quantifying defects and impurities which are present in the silicon wafer.

A method for irradiating a silicon single crystal with an electron beam and measuring carbon impurity concentration in the silicon single crystal from peak intensity of photoluminescence caused by carbon-oxygen composite defects produced in this single crystal is disclosed in Patent Document 1, and dependence of the peak intensity of such photoluminescence on both carbon concentration and oxygen concentration in a silicon single crystal is disclosed in Patent Document 2.

According to the measuring method in Patent Document 1, carbon concentration in the silicon single crystal and a ratio (an intensity ratio) of peak (G line) intensity caused by interstitial carbon-substitutional carbon composite defects in a spectrum based on the PL method to silicon peak (which is referred to as a TO line in Patent Document 1, and will be referred to as a free excitation luminescence (FE: Free Excitation) line hereinafter) intensity are acquired in accordance with each of a plurality of silicon single crystals having different carbon concentrations, and a correlation between the carbon concentration and the intensity ratio is derived in advance. Then, according to the method, the carbon concentration in a measurement silicon single crystal is measured based on the correlation and the intensity ratio of the peak acquired from the silicon single crystal (the measurement silicon single crystal) whose carbon concentration is unknown. However, oxygen concentrations in the silicon single crystals are not taken into consideration here, and the carbon concentrations can be measured in the silicon single crystals having the same oxygen concentration only (Patent Document 2).

Thus, Patent Document 3 discloses a carbon concentration evaluating method by which a correlation between a ratio of carbon concentration and oxygen concentration ([Cs]/[Oi]) in a silicon single crystal and a peak intensity ratio (G/C) of a G line after irradiation of an electron beam and a peak (a C line) caused by interstitial carbon-interstitial oxygen composite defects is obtained in advance and unknown carbon concentration is obtained from oxygen concentration in a measurement silicon single crystal and a result of the peak intensity ratio based on the correlation.

Further, paragraph [0065] in Patent Document 4 has a description that it is preferable for respective oxygen concentrations in first samples to be equal to further accurately obtain a correlation between G line intensity and an ion implantation amount of impurities since a balance between C line intensity and the G line intensity changes depending on the oxygen concentration in a silicon semiconductor.

### CITATION LIST

### PATENT LITERATURE

Patent Document 1: Japanese Unexamined Patent Application Publication No. 2013-152977
Patent Document 2: Japanese Unexamined Patent Application Publication No. H4-344443
Patent Document 3: Japanese Unexamined Patent Application Publication No. 2015-101529
Patent Document 4: Japanese Unexamined Patent Application Publication No. 2015-222801

### SUMMARY OF INVENTION

### TECHNICAL PROBLEM

As described above, in the carbon concentration measurement based on the PL method, since the peak caused by the composite defects of the carbon and the oxygen is used, many studies on correction of the oxygen concentration have been conducted. However, an extent of the oxygen concentration which requires use of a different calibration curve has been unrevealed. In case of the FZ single crystal in particular, its oxygen concentration is extremely lower than that of a CZ single crystal (a single crystal manufactured by a Czochralski (CZ) method), and it has been conventionally considered that the carbon concentration can be uneventfully quantified by one calibration curve.

However, the present inventor has found a problem that, in the event of using a polycrystalline silicon ingot (which will be referred to as pure-poly) and a CZ crystal silicon ingot (which will be referred to as a CZ single crystal), when the carbon concentration is obtained with the use of one calibration curve based on the PL method like conventional examples, a deviation between the carbon concentration obtained by the FT-IR method and the carbon concentration obtained by the PL method becomes large in an FZ single crystal using the pure-poly as a starting material in case of low concentration but, on the contrary, a deviation between the carbon concentration obtained by the FT-IR method and the carbon concentration obtained by the PL method becomes large in an FZ silicon single crystal using the CZ single crystal as a starting material in case of high concentration, and quantifying the accurate carbon concentration is difficult.

In view of the above-described problems, it is an object of the present invention to provide a method for measuring carbon concentration which enables the accurate carbon concentration measurement even if a type of a starting material differs in a semiconductor sample made of an FZ single crystal in particular in the carbon concentration measurement using the PL method.

### SOLUTION TO PROBLEM

To achieve the object, the present invention provides a method for measuring carbon concentration which obtains the carbon concentration in a measurement semiconductor sample made of an FZ silicon single crystal manufactured by a floating zone (FZ) method from measurement values measured by a photoluminescence (PL) method, the method including:
previously preparing respective FZ silicon single crystals manufactured by the FZ method from a plurality of types of starting materials which have different contained oxygen concentrations due to a difference in manufacturing methods, and creating and preparing calibration curves each indicating a relationship between a measurement value based on the photoluminescence (PL) method and the carbon concentration from standard samples made of the respective FZ silicon single crystals in accordance with the respective types of starting materials of the FZ silicon single crystals;
selecting a calibration curve of the same type of starting material as a starting material of the measurement semiconductor sample from the plurality of prepared calibration curves; and
obtaining the carbon concentration of the measurement semiconductor sample from the measurement value of the measurement semiconductor sample based on the photoluminescence method with the use of the selected calibration curve.

In this manner, since the oxygen concentration in the FZ single crystal is determined in dependence upon contained oxygen concentration of the starting material, preparing the calibration curve in accordance with each of types of the starting materials having different oxygen concentrations enables accurately quantifying the carbon concentration.

It is preferable that the plurality of calibration curves prepared in accordance with the respective types of starting materials are prepared in accordance with the standard sample whose starting material type is a polycrystalline silicon ingot (pure-poly) and the standard sample whose starting material type is a silicon single crystal ingot (CZ single crystal) pulled up by a Czochralski (CZ) method.

In this manner, the contained oxygen concentration of the pure poly is low and, on the other hand, the counterpart of the CZ single crystal is high. Thus, preparing the calibration curve in accordance with each of types of the starting materials enables the accurate carbon concentration measurement.

At this time, it is preferable that each calibration curve indicative of the relationship between the measurement values based on the PL method and the carbon concentrations is created by making reference to measurement values of carbon concentrations measured by a measuring method other than the PL method regarding the standard samples configured to obtain the calibration curves.

Further, a carbon concentration domain of the calibration curve measured by a measuring method other than the PL method can be set to 1×10¹⁴ atoms/cm³ or more.

That is, since the carbon can be detected with high sensitivity by the PL method, the lower carbon concentration can be measured as compared with any other measuring method than the PL method. Thus, in a high carbon concentration domain (e.g., a domain of 1×10¹⁴ atoms/cm³ or more) which can be quantified by a conventional method (a measuring method other than the PL method), when the calibration curve is created with the use of the carbon concentrations quantified by the conventional method and PL measurement values, the highly reliable calibration curve can be created.

Furthermore, in this case, it is preferable that as the calibration curve, one provided by extrapolating the calibration curve created by making reference to the carbon concentrations measured by the measuring method other than the PL method is prepared.

When the calibration curve provided by extrapolating the calibration curve created by making reference to the carbon concentrations measured by a measuring method other than the PL method is used, the low carbon concentration which is, e.g., approximately 1×10¹³ atoms/cm³ can be quantified.

Further, in a case where the carbon concentration in the measurement semiconductor sample has been measured as 1×10¹⁴ atoms/cm³ or more, it is preferable to verify whether the measured carbon concentration coincides with the carbon concentration measured by the measuring method other than the PL method and correct the calibration curve when they do not coincide with each other.

When the calibration curve is corrected in this manner, the further reliable calibration curve can be obtained, and the more accurate measurement can be carried out.

### ADVANTAGEOUS DEFFECTS OF INVENTION

According to the present invention, it is possible to provide the method for measuring carbon concentration which enables the accurate carbon concentration measurement even if semiconductor samples or especially semiconductor samples made of FZ single crystals have different types of starting materials and different contained oxygen concentrations.

### BRIEF DESCRIPTION OF DRAWINGS

FIG. 1 shows a conventional calibration curve in a relationship between G line intensity/FE line intensity based on a PL method and carbon concentrations based on an FT-IR method;
FIG. 2 shows a correlation between the carbon concentrations based on the FT-IR method and carbon concentrations obtained with the use of a conventional calibration curve by the PL method;
FIG. 3 shows starting material type-specific calibration curves in the relationship between the G line intensity/FE line intensity based on the PL method and the carbon concentration based on the FT-IR method; and
FIG. 4 shows a correlation between the carbon concentration based on the FT-IR method and carbon concentration obtained with the use of a calibration curve based on a method of the present invention by the PL method.

### DESCRIPTION OF EMBODIMENT

An embodiment of the present invention will now be described hereinafter, but the present invention is not restricted thereto.

Since FZ single crystals contain low oxygen, it has been conventionally considered that measurement values are not affected by the oxygen, and carbon concentration has been obtained with the use of one calibration curve by the PL method. However, it has been found out that, when starting materials whose contained oxygen concentrations are different due to a difference in manufacturing method are used, values measured by the FT-IR method greatly deviate from values obtained by the PL method. Thus, the present inventor has turned his thought to creating a calibration curve in accordance with each of the starting materials having different contained oxygen concentrations, thereby bringing the present invention to completion.

That is, the present invention is a method for measuring carbon concentration which obtains the carbon concentration in a measurement semiconductor sample made of an FZ single crystal from measurement values measured by a photoluminescence (PL) method, the method including:
previously preparing respective FZ single crystals manufactured by the FZ method from a plurality of types of starting materials which have different contained oxygen concentrations due to a difference in manufacturing methods, and creating and preparing calibration curves each indicating a relationship between a measurement value based on the photoluminescence (PL) method and the carbon concentration from standard samples made of the respective FZ single crystals in accordance with the respective types of starting materials of the FZ single crystals;
selecting a calibration curve of the same type of starting material as a starting material of the measurement semiconductor sample from the plurality of prepared calibration curves; and
obtaining the carbon concentration of the measurement semiconductor sample from the measurement value of the measurement semiconductor sample based on the photoluminescence method with the use of the selected calibration curve.

In the method for measuring carbon concentration according to the present invention, it is preferable to measure carbon concentration of a semiconductor standard sample by a measuring method other than the PL method, make reference to the measured carbon concentration of the semiconductor standard sample, create a calibration curve indicative of a relationship between a measurement value obtained by the PL method and the carbon concentration obtained by the measuring method other than the PL method, then obtain a "measurement value based on the PL method" of a measurement semiconductor sample, and obtain carbon concentration of the measurement semiconductor sample from the calibration curve.

As the method for measuring the carbon concentration of the semiconductor standard sample other than the PL method, there is, for example, a well-known FT-IR method or a SIMS method (secondary ion mass spectrometry). A carbon concentration domain to be measured by the measuring method (the FT-IR method in particular) other than the PL method can be set to 1×10¹⁴ atoms/cm³ or more, and its upper limit may be set to 5×10¹⁷ atoms/cm³ at which dislocation of the silicon single crystal does not occur.

After measuring the carbon concentration by the carbon concentration measuring method other than the PL method, a "measurement value based on the PL method" of the semiconductor standard sample is obtained. The carbon concentration measurement based on the PL method can be carried out in accordance with a conventional method. That is, the sample is irradiated with an electron beam to substitute a carbon atom (Cs) at a site of substitution with a counterpart at an interstitial site (Ci), and a carbon-oxygen composite defect which is called a G line (Ci-Cs) or a C line (Ci-Oi) is produced. The PL measurement is performed while cooling this defect with a liquid He, and each peak intensity including that of an FE line which is luminescence resulting from silicon is obtained. Further, as PL measurement values, it is possible to use G line intensity, C line intensity, G line intensity/FE line intensity or C line intensity/FE line intensity standardized with the use of the FE line intensity, and G line intensity/B (boron concentration), C line intensity/B (boron concentration), G line intensity/P (phosphorous concentration), or C line intensity/P (phosphorous concentration) standardized with the use of dopant concentration, and others.

At this time, in the present invention, a plurality of calibration curves of the carbon concentrations in the FZ single crystals are prepared in accordance with respective types of starting materials having different contained oxygen concentrations in the FZ single crystals.

Thus, to prepare the plurality of calibration curves of the carbon concentrations in the FZ single crystals in accordance with the respective types of the starting materials of the FZ single crystals in advance, phosphorous-doped FZ single crystals having a diameter of 150 mm and a resistivity of 150 Ωcm were pulled up as standard samples. The number of the FZ single crystals using a polycrystalline silicon ingot as a starting material is four, and the number of the FZ single crystals using a CZ single crystal ingot is five (the former may be referred to as pure-poly FZ and the latter may be referred to as CZ-FZ hereinafter).

Here, carbon concentration measurement values based on the FT-IR method were compared with carbon concentrations obtained from measurement values based on the PL method.

It is to be noted that low carbon concentrations can be measured by the PL method, but the crystals were daringly manufactured so that high carbon concentration which can be detected by the FT-IR method can be provided for the purpose of confirming reliability of the measurement results of the PL method by the FT-IR method.

The carbon concentration measurement based on the FT-IR method is standardized by JEITA (JEITA EM-3503), and its detection lower limit is 2×10¹⁵ atoms/cm³. A recent academic meeting has reported that 1×10¹⁴ atoms/cm³ was measured (The 76th Japan Society of Applied Physics Autumn Meeting, 13p-1E-1, 2015).

After growing the FZ single crystals which are the standard samples, a sample was sliced off from a crystal tail portion (a position which is 100 cm from a shoulder portion) of each crystal.

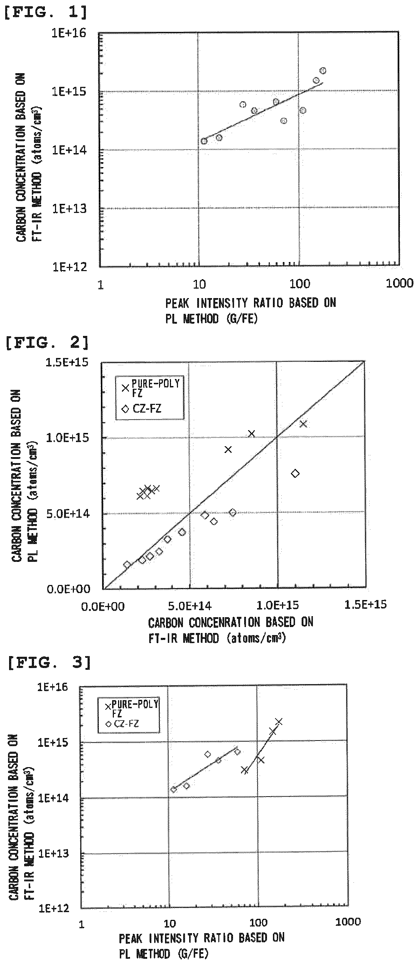

First, in a state where no electron beam is applied, the carbon concentration of each sample was measured by the FT-IR method. Then, after applying the electron beam with 2 MeV and 400 kGy, the PL measurement was performed. FIG. 1 shows a relationship (a calibration curve) between each carbon concentration quantified by the FT-IR method and the G line intensity/FE line intensity obtained by the PL measurement after the electron beam application.

Here, all the four pure-poly FZ had the oxygen concentration of 5.0×10¹⁵ atoms/cm³ at the crystal tail portion (the position which is 100 cm from the shoulder portion) of each crystal. On the other hand, the CZ-FZ had 1.3 to 2.3×10¹⁶ atoms/cm³. In this manner, there is no significant difference in oxygen concentration between the pure-poly FZ and the CZ-FZ in the FZ single crystals, the concentrations have sufficiently small values, the relationship (the calibration curve) in FIG. 1 can be regarded as one line, and hence it has been conventionally considered that no problem occurs even if the carbon concentrations are quantified with the use of one calibration curve.

Thus, as measurement samples, 10 pure-poly FZ and 10 CZ-FZ were further pulled up, and a sample was sliced off from each crystal tail portion (the position which is 100 cm from the shoulder portion). First, in a state where no electron beam is applied, the carbon concentration of each sample was measured by the FT-IR method. Then, after applying the electron beam with 2 MeV and 400 kGy, the PL measurement was performed, and the carbon concentrations were obtained in accordance with the relationship (the calibration curve) in FIG. 1.

FIG. 2 shows a relationship between the carbon concentrations obtained by the FT-IR method and the carbon concentrations obtained by the PL method with the use of the calibration curve of the conventional method in FIG. 1. In this manner, in case of the pure-poly FZ, a deviation between both types of the concentrations is considerable when the concentrations are low, and values of both the types of the concentrations are close to each other when the concentrations are high. On the other hand, in case of the CZ-FZ, it has been found out that values of both the types of the concentrations substantially coincide with each other when the concentrations are low, but a deviation between them are considerable when the concentrations are high.

It is supposed that this is caused by the use of the same calibration curve without discriminating the calibration curves depending on the pure-poly FZ and the CZ-FZ. Thus, to confirm this supposition, the present inventor has decided to obtain the calibration curve in FIG. 1 in accordance with each of types of starting materials of the FZ single crystals. This is shown in FIG. 3. It has been found out from FIG. 3 that the calibration curve of the pure-poly FZ is different from that of the CZ-FZ.

This means that it has been conventionally considered that both the pure-poly FZ and the CZ-FZ have sufficiently small oxygen concentrations, there is almost no difference between the oxygen concentrations, and one calibration curve can suffice without discriminating both the materials, but a difference in oxygen concentration between them is actually significant, and the calibration curves must be discriminated for them. That is, in FIG. 3, the CZ-FZ have smaller G/FE values than those of the pure-poly FZ to the carbon concentrations on the same level. That is, since the CZ-FZ has the higher oxygen concentrations, a C line (Ci-Oi) is prone to be formed as compared with the pure-poly FZ and, in other words, a G line (Ci-Cs) is hard to be formed, and G/FE values are small. Moreover, in case of the low oxygen concentrations like those of the pure-poly FZ or the CZ-FZ, when the carbon is present at high concentration (e.g., 2×10¹⁵ atoms/cm³ or more (analogy from FIG. 3)), sufficiently high G line intensity is formed, and an influence of the oxygen concentration is hard to see.

As described above, it has been found out that, as the accurate carbon concentration measuring method for the FZ single crystals, the calibration curves must be created in accordance with the respective starting material types of the FZ single crystals in the low carbon concentration domain which is a target of the low-temperature PL method in particular.

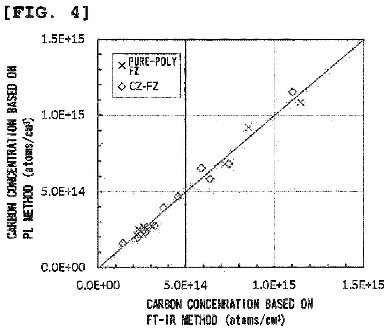

The calibration curves for the respective starting material types of the FZ single crystals were applied to the 20 FZ single crystals in accordance with the starting material types. FIG. 4 shows a relationship between the carbon concentrations obtained by the FT-IR method and the carbon concentrations obtained by the PL method based on this method using calibration curves of the pure-poly FZ and the CZ-FZ. Both the concentrations excellently coincide with each other. In this manner, it has been confirmed that the calibration curves must be prepared in accordance with the respective starting material types in case of the FZ silicon single crystals.

It is to be noted that, in case of the CZ-FZ, an influence of the contained oxygen concentration in the CZ crystal as a starting material has been confirmed.

The five CZ-FZ used for drawing of FIG. 1 or FIG. 3 and the 10 CZ-FZ used for drawing of FIG. 2 or FIG. 4 had the oxygen concentrations which range from 4.0×10¹⁷ atoms/cm³ to 1.2×10¹⁸ atoms/cm³ in a tail portion (a position which is 100 cm from a shoulder portion) of each CZ crystal as a starting material.

The oxygen concentrations in the FZ single crystals fabricated with the use of such a CZ starting material were 1.3 to 2.3×10¹⁶ atoms/cm³ likewise in each crystal tail portion (a position which is 100 cm from the shoulder portion). In this manner, it has been confirmed that since almost all of the oxygen in the CZ crystal ingots scatters in an FZ process and the oxygen concentration remaining in the FZ crystals become constant to some extent, the calibration curve of the CZ-FZ does not have to be prepared in accordance with each oxygen concentration, and one calibration curve can suffice.

That is, to quantify the carbon concentrations in the FZ single crystals, it is necessary and sufficient to prepare the calibration curves in accordance with the respective starting material types of the FZ single crystals irrespective of the oxygen concentration in the CZ crystal as the starting material.

Additionally, as to the low concentration domain which cannot be quantified by the conventional method, preparing a calibration curve obtained by extrapolating the calibration curve obtained here enables quantification and, specifically, the lower carbon concentration than 1×10¹⁴ atoms/cm³, e.g., the low carbon concentration which is approximately 1×10¹³ atoms/cm³ can be quantified when applied to the extrapolated calibration curve.

It is to be noted that, when the measured carbon concentration in a measurement semiconductor sample is high carbon concentration which is 1×10¹⁴ atoms/cm³ or more, verifying whether the measured carbon concentration coincides with carbon concentration measured by a measuring method other than the PL method enables verifying the reliability of the calibration curve. When both the concentrations do not coincide with each other, correcting the calibration curve can obtain the further reliable calibration curve.

### EXAMLE

Although the present invention will now be more specifically described hereinafter with reference to an example and a comparative example of the present invention, the present invention is not restricted to these examples.

### (Example)

As described above, calibration curves were discriminated in accordance with respective starting material types of the pure-poly FZ and the CZ-FZ in advance to obtain the calibration curves in FIG. 3.

Then, as measurement samples, each phosphorous-doped FZ single crystal which has a diameter of 150 mm and a resistivity of 150 Ωcm and uses a pure-poly or CZ single crystal as a starting material was newly grown (the former is a crystal A and the latter is a crystal B). According to the PL method, low carbon concentration can be measured, but each crystal was manufactured daringly so that high carbon concentration which can be detected by the FT-IR method can be provided to confirm the reliability of a measurement result of the PL method by the FT-IR method. A sample was sliced off from each crystal tail portion (a position which is 100 cm from a shoulder portion), a part of the sample was irradiated with an electron beam with 2 MeV and 400 kGy, and then the PL measurement was performed.

Consequently, G line intensity/FE line intensity of 88.5 was obtained in the crystal A, and the counterpart of 35.1 was obtained in the crystal B. Further, as Example, when a calibration curve of the pure-poly FZ was applied in the crystal A and a calibration curve of the CZ-FZ was applied in the crystal B in accordance with the respective starting materials to obtain carbon concentrations, the carbon concentrations in the respective samples were 4.2×10¹⁴ atoms/cm³ in the crystal A and 4.6×10¹⁴ atoms/cm³ in the crystal B.

On the other hand, remaining samples sliced off from the respective crystal tail portions were directly measured by the FT-IR to obtain carbon concentrations. As a result, both the crystals A and B had 4.4×10¹⁴ atoms/cm³, and it has been confirmed that they excellently coincide with the carbon concentration obtained by the PL method.

Subsequently, as a measurement sample, a phosphorous-doped FZ crystal which has a diameter of 150 mm and a resistivity of 150 Ωcm and uses a CZ single crystal as a starting material was prepared. At this time, the crystal was manufactured so that low carbon concentration can be provided (a crystal C). A sample was sliced off from a crystal tail portion (a position which is 100 cm from a shoulder portion), a part of the sample was irradiated with an electron beam with 2 MeV and 400 kGy, and then the PL measurement was performed.

Consequently, G/FE was 2.8. As Example, when a calibration curve of the CZ-FZ was used in accordance with a type of the starting material and it was extrapolated to a low concentration side, the carbon concentration of 3.4×10¹³ atoms/cm³ was obtained.

### (Comparative Example)

As Comparative Example, the PL measurement values (the G line intensity/FE line intensity) of the crystals A and B obtained in Example were applied to the conventional calibration curve in FIG. 1 to obtain carbon concentrations. Consequently, the crystal A had 7.7×10¹⁴ atoms/cm³ whilst the crystal B had 3.7×10¹⁹ atoms/cm³, and the carbon concentration of the crystal A (the pure-poly FZ) was largely different from the value obtained in Example or the value obtained by the FT-IR. That is because, as can be understood from a comparison between the calibration curve in FIG. 1 and those in FIG. 3, a deviation between the carbon concentrations based on the FT-IR method and the PL method in the vicinity of 4×10¹⁴ atoms/cm³ is small in the CZ-FZ but large in the pure-poly FZ.

Furthermore, when a remaining sample sliced off from the crystal tail portion of the crystal C in Example was subjected to the FT-IR method, the quantification was impossible due to a detection lower limit value or a smaller value. On the other hand, according to the method of Example, it has been confirmed that extrapolating the starting material type-specific calibration curve enables the quantification as described above.

## Claims

1. A method for measuring carbon concentration which obtains the carbon concentration in a measurement semiconductor sample made of an FZ silicon single crystal manufactured by a floating zone (FZ) method from measurement values measured by a photoluminescence (PL) method, the method comprising:
previously preparing respective FZ silicon single crystals manufactured by the FZ method from a plurality of types of starting materials which have different contained oxygen concentrations due to a difference in manufacturing methods, and creating and preparing calibration curves each indicating a relationship between a measurement value based on the photoluminescence (PL) method and the carbon concentration from standard samples made of the respective FZ silicon single crystals in accordance with the respective types of starting materials of the FZ silicon single crystals;
selecting a calibration curve of the same type of starting material as a starting material of the measurement semiconductor sample from the plurality of prepared calibration curves; and
obtaining the carbon concentration of the measurement semiconductor sample from the measurement value of the measurement semiconductor sample based on the photoluminescence method with the use of the selected calibration curve.

2. The method for measuring carbon concentration according to claim 1, wherein the plurality of calibration curves prepared in accordance with the respective types of starting materials are prepared in accordance with the standard sample whose starting material type is a polycrystalline silicon ingot and the standard sample whose starting material type is a silicon single crystal ingot pulled up by a Czochralski method.

3. The method for measuring carbon concentration according to claim 1 or 2, wherein each calibration curve indicative of the relationship between the measurement values based on the PL method and the carbon concentrations is created by making reference to measurement values of carbon concentrations measured by a measuring method other than the PL method regarding the standard samples configured to obtain the calibration curves.

4. The method for measuring carbon concentration according to claim 3, wherein a carbon concentration domain of the calibration curve measured by a measuring method other than the PL method is 1×10¹⁴ atoms/cm³ or more.

5. The method for measuring carbon concentration according to claim 3 or 4, wherein, as the calibration curve, one provided by extrapolating the calibration curve created by making reference to the carbon concentrations measured by the measuring method other than the PL method is prepared.

6. The method for measuring carbon concentration according to any one of claims 1 to 5, wherein, in a case where the carbon concentration in the measurement semiconductor sample has been measured as 1×10¹⁴ atoms/cm³ or more, whether the measured carbon concentration coincides with the carbon concentration measured by the measuring method other than the PL method is verified and the calibration curve is corrected when they do not coincide with each other.

## Patentansprüche

1. Verfahren zur Messung der Kohlenstoffkonzentration, das die Kohlenstoffkonzentration in einer Messhalbleiterprobe aus einem FZ-Siliziumeinkristall, der durch ein Floating-Zone-(FZ)-Verfahren hergestellt wurde, aus Messwerten erhält, die durch ein Photolumineszenz-(PL)-Verfahren gemessen wurden, wobei das Verfahren umfasst:
vorheriges Herstellen jeweiliger FZ-Siliziumeinkristalle, die durch das FZ-Verfahren aus einer Vielzahl von Typen von Ausgangsmaterialien hergestellt wurden, die aufgrund unterschiedlicher Herstellungsverfahren unterschiedliche Konzentrationen an enthaltenem Sauerstoff aufweisen, und Erstellen und Herstellen von Kalibrierungskurven, die jeweils eine Beziehung zwischen einem Messwert, der auf dem Photolumineszenz (PL)-Verfahren basiert, und der Kohlenstoffkonzentration aus Standardproben anzeigen, die aus den jeweiligen FZ-Siliziumeinkristallen entsprechend den jeweiligen Typen von Ausgangsmaterialien der FZ-Siliziumeinkristalle hergestellt wurden;
Auswählen einer Kalibrierungskurve desselben Typs von Ausgangsmaterial wie ein Ausgangsmaterial der Messhalbleiterprobe aus der Vielzahl der vorbereiteten Kalibrierungskurven; und
Ermitteln der Kohlenstoffkonzentration der Mess-Halbleiterprobe aus dem Messwert der Mess-Halbleiterprobe auf der Grundlage des Photolumineszenzverfahrens unter Verwendung der ausgewählten Kalibrierkurve.

2. Verfahren zur Messung der Kohlenstoffkonzentration nach Anspruch 1, wobei die mehreren Kalibrierkurven, die gemäß den jeweiligen Typen von Ausgangsmaterialien erstellt werden, gemäß der Standardprobe, deren Ausgangsmaterialtyp ein polykristalliner Siliziumblock ist, und der Standardprobe, deren Ausgangsmaterialtyp ein Silizium-Einkristallblock ist, der durch ein Czochralski-Verfahren gezogen wird, erstellt werden.

3. Verfahren zur Messung der Kohlenstoffkonzentration nach Anspruch 1 oder 2, wobei jede Kalibrierungskurve, die die Beziehung zwischen den auf dem PL-Verfahren basierenden Messwerten und den Kohlenstoffkonzentrationen angibt, durch Bezugnahme auf Messwerte von Kohlenstoffkonzentrationen erstellt wird, die durch ein anderes Messverfahren als das PL-Verfahren in Bezug auf die Standardproben gemessen wurden, die zum Erhalt der Kalibrierungskurven konfiguriert sind.

4. Verfahren zur Messung der Kohlenstoffkonzentration nach Anspruch 3, wobei ein Bereich der Kohlenstoffkonzentration der Kalibrierkurve, der mit einem anderen Messverfahren als dem PL-Verfahren gemessen wurde, 1×10¹⁴ Atome/cm³ oder mehr beträgt.

5. Verfahren zur Messung der Kohlenstoffkonzentration nach Anspruch 3 oder 4, wobei als Kalibrierungskurve eine Kurve erstellt wird, die durch Extrapolation der Kalibrierungskurve erstellt wird, die durch Bezugnahme auf die Kohlenstoffkonzentrationen, die durch das andere Messverfahren als das PL-Verfahren gemessen werden, erstellt wird.

6. Verfahren zur Messung der Kohlenstoffkonzentration nach einem der Ansprüche 1 bis 5, wobei in einem Fall, in dem die Kohlenstoffkonzentration in der Mess-Halbleiterprobe mit 1×10¹⁴ Atome/cm ³oder mehr gemessen wurde, überprüft wird, ob die gemessene Kohlenstoffkonzentration mit der Kohlenstoffkonzentration übereinstimmt, die mit einem anderen Messverfahren als dem PL-Verfahren gemessen wurde, und die Kalibrierungskurve korrigiert wird, wenn sie nicht miteinander übereinstimmen.

## Revendications

1. Procédé de mesure de la concentration en carbone qui obtient la concentration en carbone dans un échantillon de semi-conducteur de mesure constitué d'un monocristal de silicium FZ fabriqué par un procédé à zone flottante (FZ) à partir de valeurs de mesure mesurées par un procédé de photoluminescence (PL), le procédé comprenant :
la préparation au préalable de monocristaux de silicium FZ respectifs fabriqués par le procédé FZ à partir d'une pluralité de types de matières premières qui ont des concentrations en oxygène contenu différentes en raison d'une différence dans les procédés de fabrication, et la création et la préparation de courbes d'étalonnage indiquant chacune une relation entre une valeur de mesure basée sur le procédé de photoluminescence (PL) et la concentration en carbone à partir d'échantillons étalons constitués des monocristaux de silicium FZ respectifs conformément aux types respectifs de matériaux de départ des monocristaux de silicium FZ ;
la sélection d'une courbe d'étalonnage du même type de matériau de départ que le matériau de départ de l'échantillon de semi-conducteur de mesure parmi la pluralité de courbes d'étalonnage préparées ; et
l'obtention de la concentration en carbone de l'échantillon de semi-conducteur de mesure à partir de la valeur de mesure de l'échantillon de semi-conducteur de mesure sur la base du procédé de photoluminescence à l'aide de la courbe d'étalonnage sélectionnée.

2. Procédé de mesure de la concentration en carbone selon la revendication 1, dans lequel la pluralité de courbes d'étalonnage préparées conformément aux types respectifs de matières premières sont préparées en fonction de l'échantillon étalon dont le type de matière première est un lingot de silicium polycristallin et de l'échantillon étalon dont le type de matière première est un lingot monocristallin de silicium par un procédé de Czochralski.

3. Procédé de mesure de la concentration en carbone selon la revendication 1 ou 2, dans lequel chaque courbe d'étalonnage indiquant la relation entre les valeurs de mesure basées sur le procédé PL et les concentrations en carbone est créée en faisant référence à des valeurs de mesure de concentrations en carbone mesurées par un procédé de mesure autre que le procédé PL en ce qui concerne les échantillons étalons conçus pour obtenir les courbes d'étalonnage.

4. Procédé de mesure de la concentration en carbone selon la revendication 3, dans lequel un domaine de concentration en carbone de la courbe d'étalonnage mesurée par un procédé de mesure autre que le procédé PL est de 1×10¹⁴ atomes/cm³ ou plus.

5. Procédé de mesure de la concentration en carbone selon la revendication 3 ou 4, dans lequel, comme courbe d'étalonnage, celle fournie par extrapolation de la courbe d'étalonnage créée en faisant référence aux concentrations en carbone mesurées par le procédé de mesure autre que le procédé PL est préparée.

6. Procédé de mesure de la concentration en carbone selon l'une quelconque des revendications 1 à 5, dans lequel, dans un cas où la concentration en carbone dans l'échantillon de semi-conducteur de mesure a été mesurée comme étant de 1×10¹⁴ atomes/cm³ ou plus, le fait que la concentration en carbone mesurée coïncide avec la concentration en carbone mesurée par le procédé de mesure autre que le procédé PL est vérifié et la courbe d'étalonnage est corrigée lorsqu'elles ne coïncident pas l'une avec l'autre.
